# EUROPEAN PATENT APPLICATION

(11) **EP 4 682 880 A1**
(43) Date of publication of application: **21.01.2026**
(21) Application number: 25188997.8
(22) Date of filing: 11.07.2025
(51) Int. Cl.: G11C 7/12, G11C 11/419

(54) **ULTRA LOW-VOLTAGE SRAM ARCHITECTURE**

(30) Priority: 18.07.2024 US 202463672798 P; 02.06.2025 US 202519225662
(71) Applicant: STMicroelectronics International N.V., 1228 Plan-les-Ouates, Geneva (CH)
(72) Inventor: VERMA, Praveen Kumar, GREATER NOIDA 201310 (IN); SHRIVASTAVA, Sant Swaroop, AGRA UTTAR PRADESH 282005 (IN); DHORI, Kedar Janardan, GHAZIABAD 201010 (IN)
(74) Representative: Casalonga

(57) **Abstract**

Disclosed herein a static random-access memory (SRAM) circuits designed to operate reliably in scenarios where the memory array supply voltage (VDDMA) significantly exceeds the peripheral circuit supply voltage (VDDMP). Various configurations of pre-charge and pre-charge assist circuits are disclosed, each aimed at preventing unintended state changes in bitcells during read operations. These circuits employ techniques such as charge transfer from a higher voltage domain, capacitive coupling, and sense amplifier decoupling to boost bitline voltages above VDDMP during critical read phases. This enables stable SRAM operation with a large voltage differential between VDDMA and VDDMP, facilitating improvements in both performance and power efficiency.

## Description

### TECHNICAL FIELD

Disclosed herein are static random-access memory (SRAM) circuits that can maintain stable operation in scenarios where the memory array supply voltage significantly exceeds the peripheral supply voltage.

### BACKGROUND

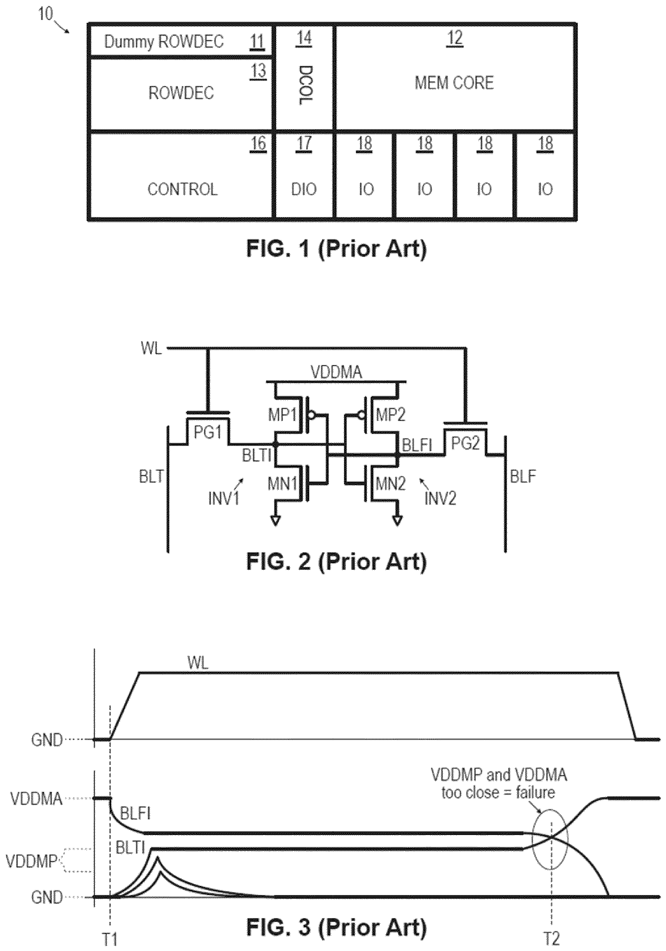

A block diagram for a conventional static random-access memory (SRAM) 10, such as may be used within a system-on-a-chip (SOC), is shown in FIG. 1. The memory 10 includes a memory core 12, and a row decoder 13 which serves the function of selecting a specific row within the memory core 12 based on a provided address input. Input/output (IO) blocks handle the input and output of data to and from the memory core 12.

A dummy column 14 aids in accounting for process variations and therefore maintaining consistent and stable performance during read and write operations performed on the memory core 12, and a dummy input/output (IO) block 17 serves a similar purpose. A dummy row decoder 11 performs an analogous function to the row decoder 13, but for the dummy column 14 rather than the main memory core 12.

A control section 16 receives control signals, such as address signals and functional commands (e.g., write enable, chip select, etc), and uses them to control the functioning of the various components, including the row decoder 13, dummy row decoder 11, dummy column 14, dummy IO 17, dummy row decoder 11, memory core 12, and IO blocks 18.

The memory core 12 is powered between a core supply voltage VDDMA and ground, while the blocks about its periphery are powered between a periphery supply voltage VDDMP and ground. VDDMP is less than VDDMA in low voltage memories. It is desired for VDDMP to be as low as possible to reduce power consumption.

An issue arises when there is a significant difference between VDDMA and VDDMP. While VDDMA is used for powering the bitcells and generating wordline WL, VDDMP is used by the pre-charge circuity (not shown) to pre-charge the bit lines BLT and BLF.

To appreciate this issue, first turn to FIG. 2, showing a standard 6T bitcell including cross coupled inverters INV1 (formed by p-channel transistor MP1 and n-channel transistor MN1) and INV2 (formed by p-channel transistor MP2 and n-channel transistor MN2). Pass gate transistor PG1 is connected between bit line BLT and node BLTI (the output of inverter INV1), and pass gate transistor PG2 is connected between complementary bit line BLTF and node BLFI (the output of inverter INV2).

Now turn to the graph of FIG. 3. Assume that BLTI is at 0 (ground) and BLFI is at 1 (VDDMA), and a read operation is being performed. It can therefore be appreciated that if WL=VDDMA and BLF=VDDMP, and if VDDMA>>VDDMP, there is a non-zero gate-to-source voltage across pass gate transistor PG2. Thus, the pass gate transistor PG2 turns on slightly, causing discharge of node BLFI. At a certain point, for certain skewed bitcells (e.g., weak), this discharge of BLFI is sufficient to turn on transistor MP1 in the bitcell, and the bit cell flips state (observe this occurring in the oval in the graph of FIG. 3). This is a problem, as this destroys the stored data. As such, further development is necessary in order to enable properly functioning SRAM memories in which VDDMA>>VDDMP for reduced power consumption.

### SUMMARY

A static random-access memory (SRAM) circuit has a memory array including a plurality of bitcells arranged in rows and columns and peripheral circuitry. The peripheral circuitry includes a row decoder and a control circuit. The memory array is powered by an array supply voltage that is higher than a peripheral supply voltage used to power the peripheral circuitry. The SRAM circuit has pre-charge circuit arrangements configured to pre-charge bitlines of the memory array to a voltage higher than the peripheral supply voltage during a read operation.

The pre-charge circuit arrangements may have a plurality of pre-charge circuits, each associated with a respective column of the memory array and configured to pre-charge the bitlines of that column to a voltage at an intermediate node. A pre-charge assist circuit may be configured to charge the voltage at the intermediate node to the voltage higher than the peripheral supply voltage during the read operation.

The pre-charge assist circuit may have a charging bitline, a first transistor configured to selectively connect the array supply voltage to the charging bitline, and a second transistor configured to selectively connect the charging bitline to the intermediate node. Each pre-charge circuit may have a third transistor configured to selectively connect the intermediate node to a first bitline of the associated column, a fourth transistor configured to selectively connect the intermediate node to a second bitline of the associated column, and a fifth transistor configured to selectively connect the peripheral supply voltage to the intermediate node.

The array supply voltage may be at least 1.5 times higher than the peripheral supply voltage.

The first transistor and second transistor may be controlled by complementary states of a control signal such that when one transistor is on, the other is off.

The SRAM circuitry may comprise a plurality of pre-charge assist circuits distributed across different columns of the memory array.

The pre-charge circuit arrangements may have a plurality of pre-charge circuits, each associated with a respective column of the memory array and configured to pre-charge the bitlines of that column to a voltage higher than the peripheral supply voltage.

Each pre-charge circuit may include a first portion configured to pre-charge the bitlines of its respective column to the peripheral supply voltage, and a second portion configured to raise those bitlines from the peripheral supply voltage to the voltage higher than the peripheral supply voltage.

Each first portion may have a first transistor connected between the peripheral supply voltage and a first of the bitlines of that column, a second transistor connected between the peripheral supply voltage and a second of the bitlines of that column, and a third transistor connected between the first bit line and the second bit line. The first transistor, second transistor, and third transistor may each be controlled by a pre-charge control voltage.

The pre-charge control voltage and a pre-charge coupling voltage may be applied in a predetermined sequence during the read operation.

Each second portion may raise the bitlines from the peripheral supply voltage to the voltage higher than the peripheral supply voltage by applying a pre-charge coupling voltage at capacitors connected to the bitlines.

The pre-charge coupling voltage may be substantially equal to the array supply voltage.

Each second portion may raise the bitlines by at least 10% above the peripheral supply voltage.

The pre-charge circuit arrangements may have a plurality of pre-charge circuits, each associated with a respective column of the memory array and configured to pre-charge the bitlines of that column to the voltage greater than the peripheral supply voltage, a plurality of sense amplifiers, each associated with a respective column of the memory array and configured to sense voltages on the bitlines of that column, and decoupling capacitors connected between respective ones of the plurality of pre-charge circuits and the plurality of sense amplifiers.

Each sense amplifier may comprise cross-coupled inverters powered between the peripheral supply voltage and a sense amplifier enable node.

Each of the plurality of pre-charge circuits may have a first transistor connected between the array supply voltage and a first of the bitlines for that pre-charge circuit, the first transistor controlled by a pre-charge control voltage, a second transistor connected between the first of the bitlines and a first decoupling node, the second transistor controlled by a control signal, a third transistor connected between the first of the bitlines and the first decoupling node, the third transistor controlled by the pre-charge control voltage, a fourth transistor connected between the array supply voltage and a second of the bitlines for that pre-charge circuit, the fourth transistor controlled by a pre-charge control voltage, a fifth transistor connected between the second of the bitlines and a second decoupling node, the fifth transistor controlled by the control signal, and a sixth transistor connected between the second of the bitlines and the second decoupling node, the sixth transistor controlled by the pre-charge control voltage.

The SRAM circuitry may further comprise write transistors connected between respective bitlines and ground, the write transistors controlled by write control signals.

Respective ones of the decoupling capacitors may be connected between the plurality of pre-charge circuits and corresponding ones of the first and second decoupling nodes.

The decoupling capacitors may be pre-charged to the array supply voltage before connecting to the bitlines.

A static random-access memory (SRAM) circuit has a memory array including a plurality of bitcells arranged in rows and columns, a plurality of pre-charge circuits, each associated with a respective column of the memory array, and a pre-charge assist circuit. The pre-charge circuits and the pre-charge assist circuit are configured to charge bitlines of the memory array to a voltage higher than a peripheral supply voltage during a read operation, wherein the memory array is powered by an array supply voltage higher than the peripheral supply voltage.

The pre-charge assist circuit may have a charging bitline, a first transistor configured to selectively connect the array supply voltage to the charging bitline, and a second transistor configured to selectively connect the charging bitline to an intermediate node of each pre-charge circuit.

Each pre-charge circuit may have a third transistor configured to selectively connect the intermediate node to a first bitline of the associated column, a fourth transistor configured to selectively connect the intermediate node to a second bitline of the associated column, and a fifth transistor configured to selectively connect the peripheral supply voltage to the intermediate node.

Each pre-charge circuit may have a first capacitor connected between a first bitline of the associated column and a pre-charge assist voltage node, a second capacitor connected between a second bitline of the associated column and the pre-charge assist voltage node, and control circuitry configured to apply a voltage to the pre-charge assist voltage node to transfer charge to the first and second bitlines.

Each pre-charge circuit may have a sense amplifier powered by the peripheral supply voltage, a first capacitor and a second capacitor, a first switch configured to selectively connect a first bitline of the associated column to a first node of the first capacitor, a second switch configured to selectively connect a second bitline of the associated column to a first node of the second capacitor, a third switch configured to selectively connect the array supply voltage to a second node of the first capacitor, and a fourth switch configured to selectively connect the array supply voltage to a second node of the second capacitor.

The sense amplifier may have a pair of cross-coupled inverters.

A method of operating a static random-access memory (SRAM) circuit includes pre-charging bitlines of a memory array to a voltage higher than a peripheral supply voltage, wherein the memory array is powered by an array supply voltage higher than the peripheral supply voltage, activating a wordline to connect a selected bitcell to the pre-charged bitlines, and reading data from the selected bitcell while maintaining the bitlines at a voltage sufficient to prevent unintended state changes in the bitcell.

Pre-charging the bitlines may include charging a charging bitline to the array supply voltage, connecting the charging bitline to an intermediate node, and connecting the intermediate node to the bitlines.

Pre-charging the bitlines may include applying a voltage to a pre-charge assist voltage node connected to the bitlines through capacitors to transfer charge to the bitlines.

A static random-access memory (SRAM) circuit has a memory array including a plurality of bitcells arranged in rows and columns, a plurality of sense amplifier circuits, each associated with a respective column of the memory array, and a plurality of pre-charge boost circuits, each associated with a respective sense amplifier circuit. Each pre-charge boost circuit includes a first capacitor and a second capacitor, a first switch configured to selectively connect a first bitline of the associated column to a first node of the first capacitor, a second switch configured to selectively connect a second bitline of the associated column to a first node of the second capacitor, a third switch configured to selectively connect a first power supply voltage to a second node of the first capacitor, and a fourth switch configured to selectively connect the first power supply voltage to a second node of the second capacitor. The pre-charge boost circuit is configured to charge the first and second bitlines to a voltage higher than a second power supply voltage during a read operation, the first power supply voltage being higher than the second power supply voltage.

Each sense amplifier may have a fifth switch and a sixth switch configured to selectively connect the sense amplifier to the first and second bitlines, respectively.

The SRAM circuit may have control circuitry configured to close the third and fourth switches to charge the second nodes of the first and second capacitors to the first power supply voltage, open the third and fourth switches and close the first and second switches to transfer charge from the first and second capacitors to the first and second bitlines, respectively, and activate a wordline to connect a selected bitcell to the first and second bitlines.

Each pre-charge boost circuit may further have a seventh switch configured to selectively connect the first power supply voltage to the first bitline, and an eighth switch configured to selectively connect the first power supply voltage to the second bitline.

The first power supply voltage may be a memory array supply voltage and the second power supply voltage may be a peripheral circuit supply voltage.

### BRIEF DESCRIPTION OF THE DRAWINGS

FIG. 1 is a block diagram of a known SRAM memory showing the memory core and peripheral circuitry.
FIG. 2 is a block diagram of a standard 6T SRAM cell, such as may be used in the SRAM memory of Fig. 1.
FIG. 3 is a graph of voltages of the SRAM memory of FIG. 1 when operating in a regime where the memory array voltage significantly exceeds the peripheral circuitry voltage, illustrating why this SRAM memory is unable to do so.
FIG. 4 is a schematic diagram of a first embodiment of a SRAM memory disclosed herein capable of proper operation in a regime where the memory array voltage significantly exceeds the peripheral circuitry voltage.
FIG. 4A is a schematic diagram of the first embodiment of a SRAM memory disclosed herein capable of proper operation in a regime where the memory array voltage significantly exceeds the peripheral circuitry voltage, showing how there may be multiple of the pre-charge assist circuits.
FIG. 5 is a graph of voltages of the SRAM memory of FIG. 4 during operation.
FIG. 6 is a schematic diagram of a second embodiment of a SRAM memory disclosed herein capable of proper operation in a regime where the memory array voltage significantly exceeds the peripheral circuitry voltage.
FIG. 7 is a graph of voltages of the SRAM memory of FIG. 6 during operation.
FIG. 8 is a schematic diagram of a third embodiment of a SRAM memory disclosed herein capable of proper operation in a regime where the memory array voltage significantly exceeds the peripheral circuitry voltage.
FIG. 9 is a graph of voltages of the SRAM memory of FIG. 8 during operation.

### DETAILED DESCRIPTION

The following disclosure enables a person skilled in the art to make and use the subject matter described herein. The general principles outlined in this disclosure can be applied to embodiments and applications other than those detailed above without departing from the spirit and scope of this disclosure. It is not intended to limit this disclosure to the embodiments shown, but to accord it the widest scope consistent with the principles and features disclosed or suggested herein.

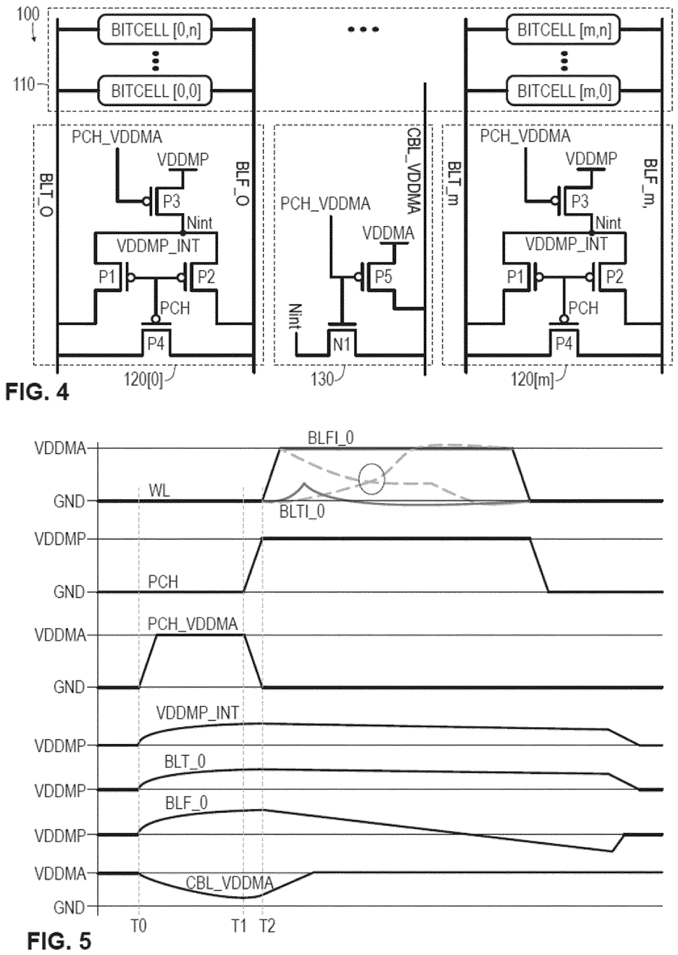

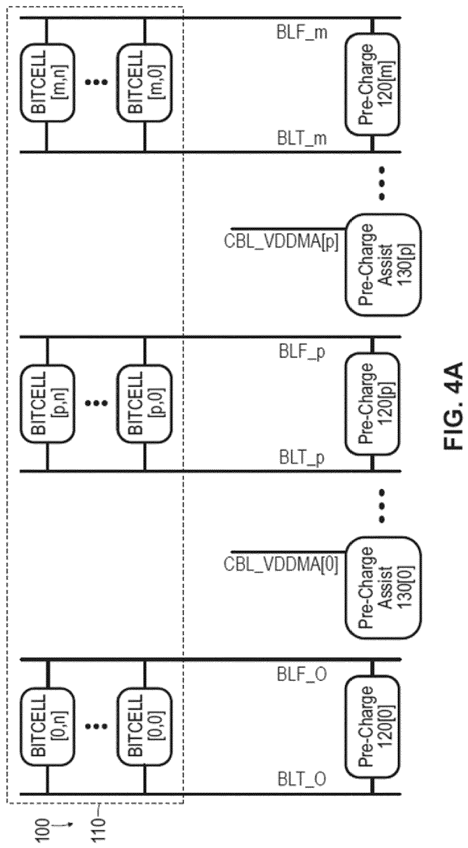

An SRAM memory 100 capable of functioning properly in a supply regime in which VDDMA>>VDDMP is now described with reference to FIG. 4. The SRAM memory 100 includes a memory array 110 comprised of (*n* + 1) by (m + 1) bitcells; therefore, columns 0 to m are present, as are rows 0 to n.

The SRAM memory 100 includes m + 1 pre-charge circuits, labelled as 120[0], ..., 120[m], as well as a pre-charge assist circuit 130. Note that although one pre-charge assist circuit 130 is shown in the embodiment of FIG. 4, there may be any number of such pre-charge assist circuits as shown in the embodiment of FIG. 4A. For example, as shown, there may be p columns of pre-charge assist circuits, with p being any integer greater than 0 and less than m.

Each pre-charge circuit 120[0], ..., 120[m] includes its own p-channel transistors P1, P2 having their gates both receiving a pre-charge enable signal PCH, with P1 having its source connected to an intermediate node Nint and its drain connected to the bit line for the column in which that pre-charge circuit resides (e.g., BLT_0 for column 0), and with P2 having its source connected to Nint and its drain connected to the complementary bit line for the column (e.g., BLF_0 for column 0). Each pre-charge circuit 120[0], ..., 120[m] further includes its own p-channel transistor P3 having its gate receiving a control signal PCH_VDDMA, its source connected to VDDMP, and its drain connected to Nint, as well as its own p-channel transistor P4 having its gate receiving the pre-charge enable signal PCH, its source connected to the bit line for the column in which that pre-charge circuit resides, and its drain connected to the complementary bit line for the column.

Pre-charge assist circuit 130 includes p-channel transistor P5 having its source connected to VDDMA, its drain connected to a charging bit-line labelled as CBL_VDDMA, and its gate receiving the control signal PCH_VDDMA, as well as n-channel transistor N1 having its source connected to the intermediate node Nint, its drain connected to the charging bit-line CBL_VDDMA, and its gate receiving the control signal PCH_VDDMA.

Referring additionally to the graphs of FIG. 5, during a read operation (shown here for column 0 as an example), assuming that BLTI[0] is at 0 (ground) and BLFI[0] is at 1 (VDDMA), at time T0, the control signal PCH_VDDMA is transitioned to a logic high. This has the effect of turning off p-channel transistor P3 in the pre-charge circuit 120[0], turning off p-channel transistor P5 in the pre-charge assist circuit 130 while turning on n-channel transistor N1 in the pre-charge assist circuit 130 to connect the charging bit-line CBL_VDDMA to the intermediate node Nint. Thus here, the voltage VDDMP_INT at intermediate node Nint rises higher than VDDMP as charge is transferred from CBL_VDDMA to Nint (since CBL_VDDMA is charged to VDDMA through the turn-on of p-channel transistor P5 when PCH_VDDMA is transitioned to a logic low, which occurred prior to time T0). Also, at time T0, the pre-charge enable signal PCH is at a logic low, turning on p-channel transistors P1, P2, and P4 in the pre-charge circuit 120[0], connecting intermediate node Nint to bit line BLT_0 and complementary bit line BLF_0. Thus, bit line BLT_0 and complementary bit line BLF_0 both rise along with the voltage VDDMP_INT.

At time T1, PCH_VDDMA is transitioned to a logic low while the pre-charge enable signal PCH is transitioned to a logic high. This has the effect of turning off p-channel transistors P1, P2, and P4 in the pre-charge circuit 120[0] while turning on p-channel transistor P5 and turning off n-channel transistor N1 in the pre-charge assist circuit 130, connecting the charging bit-line CBL_VDDMA to VDDMA so that it begins to charge up again.

At time T2, the word line WL is transitioned to a logic high so that the bitcell of the selected row within column 0 is read. Since here the bit line BLT_0 and complementary bit line BLF_0 have been pre-charged to VDDMP_INT, which is higher than VDDMP, the concern mentioned within the background of pass gate transistor PG2 within the bit cell turning on to cause discharge of BLFI_0 does not occur, and therefore the bit cell does not change state.

Thus, the SRAM memory 100 provides for stable operation in a state where the memory array supply voltage VDDMA greatly exceeds the periphery voltage VDDMP, providing for a performance gain of over 60% and 100% dynamic power gain.

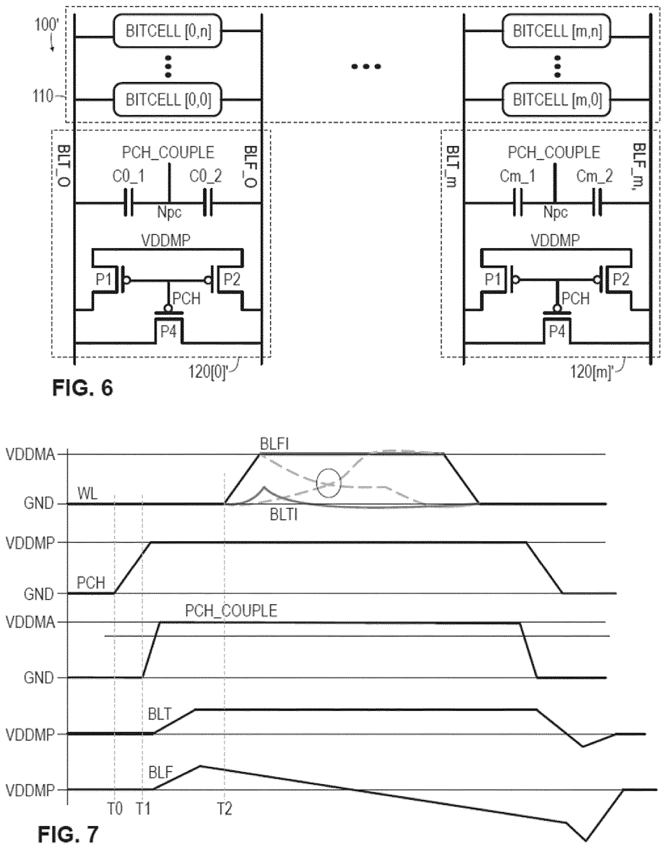

Other techniques for boosting the voltages on the bit lines BLTI and complementary bit line BLTF during read operations are within the scope of this disclosure. Refer now to FIG. 6, showing an embodiment in which the pre-charge assist circuit 130 is not present. Here, each pre-charge circuit 120[0]', ..., 120[m]' includes its own p-channel transistors P1, P2 having their gates both receiving a pre-charge enable signal PCH, with P1 having its source receiving VDDMP and its drain connected to the bit line for the column in which that pre-charge circuit resides (e.g., BLT_0 for column 0), and with P2 having its source receiving VDDMP and its drain connected to the complementary bit line for the column (e.g., BLF_0 for column 0). Each pre-charge circuit 120[0]', ..., 120[m]' further includes its own p-channel transistor P4 having its gate receiving the pre-charge enable signal PCH, its source connected to the bit line for the column in which that pre-charge circuit resides, and its drain connected to the complementary bit line for the column. Each pre-charge circuit 120[0]', ..., 120[m]' also includes a first capacitor (e.g., C0_1 for column 0) connected between the bit line for the column in which that pre-charge circuit resides and a pre-charge assist voltage node Npc (at which a voltage PCH_COUPLE is received), and a second capacitor (e.g., C0_2 for column 0) connected between the complementary bit line for the column in which that pre-charge circuit resides and the pre-charge assist voltage node Npc.

Referring additionally to the graphs of FIG. 7, during a read operation (shown here for column 0 as an example), assuming that BLTI[0] is at 0 (ground) and BLFI[0] is at 1 (VDDMA), at time T0, the control signal PCH is transitioned to a logic high, having the effect of turning off transistors P1, P2, and P4 in the pre-charge circuit 120[0]'. Note that the bit line BLT_0 and complementary bit line BLF_0 were pre-charged to VDDMP prior to time T0. At time T1, the control signal PCH_COUPLE at the pre-charge assist voltage node Npc is transitioned to VDDMA, having the effect of transferring charge to the capacitors C0_1 and C0_2, with the result being that bit line BLT_0 and complementary bit line BLF_0 both rise.

At time T2, the word line WL is transitioned to a logic high so that the bitcell of the selected row within column 0 is read. Since here the bit line BLT_0 and complementary bit line BLF_0 have been pre-charged to a voltage that is higher than VDDMP, the concern mentioned within the background of pass gate transistor PG2 within the bit cell turning on to cause discharge of BLFI_0 does not occur, and therefore the bit cell does not change state.

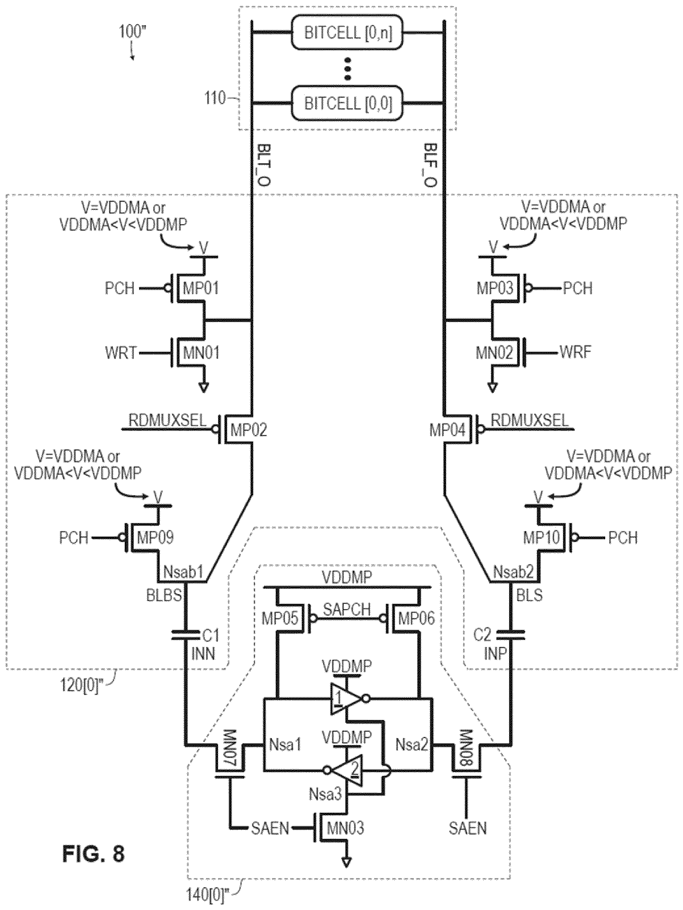

A further embodiment is shown in FIG. 8. Here, for each column there is a sense amplifier 140[0]", ..., 140[m]" includes its own p-channel transistors MP05, MP06 having their gates both receiving a sense amplifier pre-charge enable signal SAPCH, with MP05 having its source connected to a periphery supply node VDDMP and its drain connected to a first node Nsa1 for the column in which that pre-charge circuit resides (e.g., BLT_0 for column 0), and with MP06 having its source connected to VDDMP and its drain connected to a second node Nsa2 for the column. Each sense amplifier140[0]", ..., 140[m]" further includes a pair of cross coupled inverters 1 and 2, with inverter 1 having its input connected to node Nsa1 and its output connected to node Nsa2, and with inverter 2 having its input connected to node Nsa2 and its output connected to node Nsa1. Inverters 1 and 2 are powered between the periphery voltage VDDMP and a voltage at node Nsa3. Each sense amplifier 140[0]", ..., 140[m]" further includes an n-channel transistor MN03 its drain connected to node Nsa3 and its source connected to ground, with the gate of MN03 receiving a sense amplifier enable signal SAEN. Each sense amplifier 140[0]", ..., 140[m]" also includes an n-channel transistor MN07 having its source connected to node Nsa1 and its drain connected to a first terminal of capacitor C1, with its gate receiving SAEN, as well as an n-channel transistor MN08 having its source connected to node Nsa2 and its drain connected to a second terminal of capacitor C2, with its gate also receiving SAEN.

Each sense amplifier 140[0]", ..., 140[m]" is also associated with a corresponding a pre-charge circuit 120[0]", ..., 120[m]". Each pre-charge circuit 120[0]", ..., 120[m]" includes capacitor C1 having its second terminal connected to node Nsab1, capacitor C2 having its second terminal connected to node Nsa2, and p-channel transistors MP09 and MP10 having their gates receiving a pre-charge control signal PCH, with MP09 having its source connected to a supply node at which a voltage V is present (with V being equal to VDDMA or greater than VDDMP but less than VDDMA) and its drain connected to node Nsab1, and with MP10 having its source connected to the supply node to receive the voltage V and its drain connected to node Nsab2.

Each pre-charge circuit 120[0]", ..., 120[m]" includes p-channel transistors MP02 and MP04 having their gates receiving a control signal RDMUXSEL, with MP02 having its source connected to the bitline for the column in which that pre-charge circuit resides (e.g., BLT_0 for column 0) and its drain connected to node Nsab1, and with MP04 having its source connected to the complementary bitline for the column in which that pre-charge circuit resides (e.g., BLF_0 for column 0) and its drain connected to node Nsab2.

Each pre-charge circuit 120[0]", ..., 120[m]" additionally includes p-channel transistors MP01 and MP03 having their gates receiving the pre-charge control signal PCH, with MP01 having its source connected to the supply node to receive the voltage V and its drain connected to the bit line for that pre-charge boost circuit, and with MP03 having its source connected to the supply node to receive the voltage V and its drain connected to the complementary bit line for that pre-charge boost circuit. Also, each pre-charge circuit 120[0]", ..., 120[m]" includes n-channel transistor MN01 having its drain connected to the bit line for that pre-charge boost circuit, its source connected to ground, and gate receiving a control signal WRT, as well as n-channel transistor MN02 having its drain connected to the complementary bit line for that pre-charge boost circuit, its source connected to ground, and a gate receiving a control signal WRF.

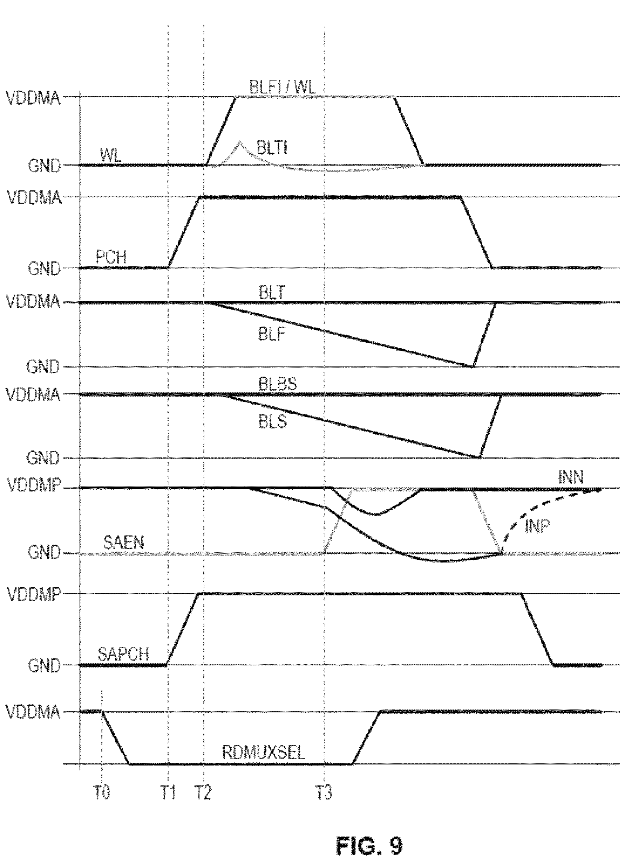

Operation is now described with further reference to FIG. 9, during a read operation (shown here for column 0 as an example), assuming that BLTI_0 is at 0 (ground) and BLFI_0 is at 1 (VDDMA), prior to time T0, the pre-charge control signal PCH is at a logic low so that p-channel transistors MP09 and MP10 are on to charge nodes BLBS and BLS (the second terminals of capacitors C1 and C2) to VDDMA.

At time T0, control signal RDMUXSEL is transitioned to a logic low, turning on p-channel transistors MP02 and MP04 to connect bit line BLT_0 and complementary bit line BLF_0 to nodes Nsab1 and Nsab2.

At time T1, control signals SAPCH and PCH are transitioned to a logic high, turning off transistors MP05 and MP06, as well as transistors MP01, MP03, MP09 and MP10.

Due to the pre-charge of BLT_0 and BLF_0 to VDDMA and the connection thereof to capacitors C1 and C2, when word line WL is transitioned to a logic high at time T2, the concern mentioned within the background of pass gate transistor PG2 within the bit cell turning on to cause discharge of BLFI_0 does not occur, and therefore the bit cell does not change state. Due to the decoupling provided by capacitors C1 and C2, the sense amplifier 140[0]" can operate in the VDDMP domain. Since the second terminals (e.g., top plates, referring to FIG. 8) of capacitors C1 and C2 are charged to VDDMA, when transistors MP02 and MP04 are turned on, the bit line BLT_0 and complementary bit line BLF_0 are maintained, with changes thereto resulting from the read and not from flipping of the state of the bit cell due to discharge of BLFI_0, which can be seen after time T3 when SAEN is transitioned to a logic high to activate the sense amplifier 140[0]".

This embodiment of the SRAM memory 100" provides several advantages for operation in scenarios where VDDMA significantly exceeds VDDMP. By employing a pre-charge boost with capacitive coupling, the design ensures that bit lines and complementary bit lines are maintained at a higher voltage differential read operations, effectively preventing unintended state changes in the bitcells. The decoupling provided by capacitors C1 and C2 allows the sense amplifier to operate in the lower VDDMP domain while still interfacing with the higher voltage bit lines, enabling power savings in the peripheral circuitry. Furthermore, this approach maintains read stability without requiring complex voltage level shifting circuits, leading to a more area-efficient design. The separation of the memory array and peripheral voltage domains also allows for independent optimization of performance and power consumption in each domain. Overall, this architecture enables the SRAM to operate reliably with a large voltage differential between VDDMA and VDDMP, facilitating improvements in both performance and power efficiency in advanced semiconductor processes where such voltage differentials are increasingly common.

Finally, it is evident that modifications and variations can be made to what has been described and illustrated herein without departing from the scope of this disclosure.

Although this disclosure has been described with a limited number of embodiments, those skilled in the art, having the benefit of this disclosure, can envision other embodiments that do not deviate from the disclosed scope. Furthermore, skilled persons can envision embodiments that represent various combinations of the embodiments disclosed herein made in various ways.

## Claims

1. A static random-access memory (SRAM) circuit, comprising:
o a memory array including a plurality of bitcells arranged in rows and columns and peripheral circuitry,
o the peripheral circuitry including a row decoder and a control circuit,
o the memory array being powered by an array supply voltage that is higher than a peripheral supply voltage used to power the peripheral circuitry;
o pre-charge circuit arrangements configured to pre-charge bitlines of the memory array to a voltage higher than the peripheral supply voltage during a read operation.

2. The SRAM circuitry of claim 1, wherein the pre-charge circuit arrangements comprise:
o a plurality of pre-charge circuits, each associated with a respective column of the memory array and configured to pre-charge the bitlines of that column to a voltage at an intermediate node; and
o a pre-charge assist circuit configured to charge the voltage at the intermediate node to the voltage higher than the peripheral supply voltage during the read operation.

3. The SRAM circuitry of claim 2,
o wherein the pre-charge assist circuit comprises:
• a charging bitline;
• a first transistor configured to selectively connect the array supply voltage to the charging bitline; and
• a second transistor configured to selectively connect the charging bitline to the intermediate node; and
o wherein each pre-charge circuit comprises:
• a third transistor configured to selectively connect the intermediate node to a first bitline of the associated column;
• a fourth transistor configured to selectively connect the intermediate node to a second bitline of the associated column; and
• a fifth transistor configured to selectively connect the peripheral supply voltage to the intermediate node.

4. The SRAM circuitry of claim 3, wherein the first transistor and second transistor are controlled by complementary states of a control signal such that when one transistor is on, the other is off.

5. The SRAM circuitry of claim 1, wherein each pre-charge circuit includes a first portion configured to pre-charge the bitlines of its respective column to the peripheral supply voltage, and a second portion configured to raise those bitlines from the peripheral supply voltage to the voltage higher than the peripheral supply voltage.

6. The SRAM circuitry of claim 5, wherein each first portion comprises:
o a first transistor connected between the peripheral supply voltage and a first of the bitlines of that column;
o a second transistor connected between the peripheral supply voltage and a second of the bitlines of that column; and
o a third transistor connected between the first bit line and the second bit line;
o wherein the first transistor, second transistor, and third transistor are each controlled by a pre-charge control voltage.

7. The SRAM circuitry of claim 5, wherein each second portion raises the bitlines from the peripheral supply voltage to the voltage higher than the peripheral supply voltage by applying a pre-charge coupling voltage at capacitors connected to the bitlines.

8. The SRAM circuitry of claim 1, wherein the pre-charge circuit arrangements comprise:
o a plurality of pre-charge circuits, each associated with a respective column of the memory array and configured to pre-charge the bitlines of that column to the voltage greater than the peripheral supply voltage;
o a plurality of sense amplifiers, each associated with a respective column of the memory array and configured to sense voltages on the bitlines of that column; and
o decoupling capacitors connected between respective ones of the plurality of pre-charge circuits and the plurality of sense amplifiers.

9. The SRAM circuitry of claim 8, wherein each sense amplifier comprises cross-coupled inverters powered between the peripheral supply voltage and a sense amplifier enable node.

10. The SRAM circuitry of claim 8, wherein each of the plurality of pre-charge circuits comprises:
o a first transistor connected between the array supply voltage and a first of the bitlines for that pre-charge circuit, the first transistor controlled by a pre-charge control voltage;
o a second transistor connected between the first of the bitlines and a first decoupling node, the second transistor controlled by a control signal;
o a third transistor connected between the first of the bitlines and the first decoupling node, the third transistor controlled by the pre-charge control voltage;
o a fourth transistor connected between the array supply voltage and a second of the bitlines for that pre-charge circuit, the fourth transistor controlled by a pre-charge control voltage;
o a fifth transistor connected between the second of the bitlines and a second decoupling node, the fifth transistor controlled by the control signal; and
o a sixth transistor connected between the second of the bitlines and the second decoupling node, the sixth transistor controlled by the pre-charge control voltage.

11. The SRAM circuitry of claim 10, wherein respective ones of the decoupling capacitors are connected between the plurality of pre-charge circuits and corresponding ones of the first and second decoupling nodes.

12. The SRAM circuitry of claim 11, wherein the decoupling capacitors are pre-charged to the array supply voltage before connecting to the bitlines.

13. The static random-access memory (SRAM) circuit of claim 1, comprising:
o a pre-charge assist circuit;
o wherein the pre-charge circuits and the pre-charge assist circuit are configured to charge bitlines of the memory array to a voltage higher than a peripheral supply voltage during a read operation, wherein the memory array is powered by an array supply voltage higher than the peripheral supply voltage.

14. The SRAM circuit of claim 13, wherein the pre-charge assist circuit comprises:
o a charging bitline;
o a first transistor configured to selectively connect the array supply voltage to the charging bitline; and
o a second transistor configured to selectively connect the charging bitline to an intermediate node of each pre-charge circuit;
wherein each pre-charge circuit comprises:
o a third transistor configured to selectively connect the intermediate node to a first bitline of the associated column;
o a fourth transistor configured to selectively connect the intermediate node to a second bitline of the associated column; and
o a fifth transistor configured to selectively connect the peripheral supply voltage to the intermediate node.

15. The SRAM circuit of claim 14, wherein each pre-charge circuit comprises:
o a first capacitor connected between a first bitline of the associated column and a pre-charge assist voltage node;
o a second capacitor connected between a second bitline of the associated column and the pre-charge assist voltage node; and
o control circuitry configured to apply a voltage to the pre-charge assist voltage node to transfer charge to the first and second bitlines.

16. The SRAM circuit of claim 13, wherein each pre-charge circuit comprises:
o a sense amplifier powered by the peripheral supply voltage;
o a first capacitor and a second capacitor;
o a first switch configured to selectively connect a first bitline of the associated column to a first node of the first capacitor;
o a second switch configured to selectively connect a second bitline of the associated column to a first node of the second capacitor;
o a third switch configured to selectively connect the array supply voltage to a second node of the first capacitor; and
o a fourth switch configured to selectively connect the array supply voltage to a second node of the second capacitor.

17. A method of operating a static random-access memory (SRAM) circuit, the method comprising:
o pre-charging bitlines of a memory array to a voltage higher than a peripheral supply voltage, wherein the memory array is powered by an array supply voltage higher than the peripheral supply voltage;
o activating a wordline to connect a selected bitcell to the pre-charged bitlines; and
o reading data from the selected bitcell while maintaining the bitlines at a voltage sufficient to prevent unintended state changes in the bitcell.

18. The method of claim 17, wherein pre-charging the bitlines comprises:
o charging a charging bitline to the array supply voltage;
o connecting the charging bitline to an intermediate node; and
o connecting the intermediate node to the bitlines.

19. The method of claim 17, wherein pre-charging the bitlines comprises:
o applying a voltage to a pre-charge assist voltage node connected to the bitlines through capacitors to transfer charge to the bitlines.

20. A static random-access memory (SRAM) circuit, comprising:
o a memory array including a plurality of bitcells arranged in rows and columns;
o a plurality of sense amplifier circuits, each associated with a respective column of the memory array; and
o a plurality of pre-charge boost circuits, each associated with a respective sense amplifier circuit;
o wherein each pre-charge boost circuit includes:
o a first capacitor and a second capacitor;
o a first switch configured to selectively connect a first bitline of the associated column to a first node of the first capacitor;
o a second switch configured to selectively connect a second bitline of the associated column to a first node of the second capacitor;
o a third switch configured to selectively connect a first power supply voltage to a second node of the first capacitor; and
o a fourth switch configured to selectively connect the first power supply voltage to a second node of the second capacitor;
o wherein the pre-charge boost circuit is configured to charge the first and second bitlines to a voltage higher than a second power supply voltage during a read operation, the first power supply voltage being higher than the second power supply voltage.

21. The SRAM circuit of claim 20, wherein each sense amplifier comprises:
o a fifth switch and a sixth switch configured to selectively connect the sense amplifier to the first and second bitlines, respectively.

22. The SRAM circuit of claim 20, further comprising control circuitry configured to:
o close the third and fourth switches to charge the second nodes of the first and second capacitors to the first power supply voltage;
o open the third and fourth switches and close the first and second switches to transfer charge from the first and second capacitors to the first and second bitlines, respectively; and
o activate a wordline to connect a selected bitcell to the first and second bitlines.

23. The SRAM circuit of claim 20, wherein each pre-charge boost circuit further comprises:
o a seventh switch configured to selectively connect the first power supply voltage to the first bitline; and
o an eighth switch configured to selectively connect the first power supply voltage to the second bitline.

24. The SRAM circuit of claim 20, wherein the first power supply voltage is a memory array supply voltage and the second power supply voltage is a peripheral circuit supply voltage.
